# EUROPÄISCHE PATENTANMELDUNG

(11) **EP 0 855 599 A2**
(43) Veröffentlichungstag der Anmeldung: **29.07.1998**
(21) Anmeldenummer: 98101076.2
(22) Anmeldetag: 22.01.1998
(51) Int. Cl.: G01R 33/09, G01C 17/26

(54) **Elektronischer Kompass**

(30) Priorität: 24.01.1997 DE 29701180 U; 16.04.1997 DE 19715931
(71) Anmelder: SIEMENS AKTIENGESELLSCHAFT, 80333 München (DE)
(72) Erfinder: Kutzner, Michael, 93049 Regensburg (DE); Hufgard, Erich, 93049 Regensburg (DE)

(57) **Zusammenfassung**

Elektronischer Kompass, bei dem ein gegenüber einem Magnetfeldsensor (MS) drehbar gelagerter, sich selbständig auf das Erdmagnetfeld ausrichtender Magnet (M) vorgesehen ist und bei dem sich der elektronische Magnetfeldsensor (MS) im Einflußbereich eines vom Magneten (M) erzeugten Magnetfeldes (H) befindet. Bevorzugt ist mindestens ein in einer Differential-Brückenschaltung angeordneter Magnetowiderstand mit einer festen Bezugsachse vorgesehen, dessen elektrischer Widerstand von einem Drehwinkel zwischen der festen Bezugsachse und der Richtung des Magnetfeldes abhängig ist.

## Beschreibung

Die Erfindung bezieht sich auf einen elektronischen Kompass mit einem elektronischen Magnetfeldsensor gemäß dem Oberbegriff des Patentanspruches 1.

Eine Vorrichtung zum Erfassen einer Winkelposition eines Objektes bezüglich einer vorgegebenen Null-Lage mit einem Magnetowiderstand(MR)-Sensor, der eine feste Bezugsachse aufweist sowie in einem Magnetfeld angeordnet ist, ist beispielsweise aus der europäischen Patentschrift EP 680 614 B1 bekannt.

Aus der US 4,640,016 ist ein Kompass bekannt, bei dem magnetoohmsche Geber (Transmitter) im Magnetfeld eines Magnetkompasses angeordnet sind. Die Empfindlichkeit, d.h. die Auflösung bezüglich des Drehwinkels dieses Kompasses ist jedoch aufgrund der zu geringen Empfindlichkeit der magnetoohmschen Geber nicht zufriedenstellend.

Der vorliegenden Erfindung liegt die Aufgabe zu Grunde, einen verbesserten elektronischen Kompass der eingangs genannten Art zu entwickeln, der insbesondere eine erhöhte Anzeigegenauigkeit aufweist.

Diese Aufgabe wird durch einen elektronischen Kompass mit den Merkmalen des Anspruches 1 gelöst. Vorteilhafte Weiterbildungen sind Gegenstand der Unteranspruche 2 bis 15.

Erfindungsgemäß weist die Differential-Brückenschaltung zusätzlich zum ersten Magnetowiderstand einen zweiten Magnetowiderstand auf, und sind die Magnetisierungen (M_{MR1}, M_{MR2}) des ersten (MR1) und des zweiten Magnetowiderstand (MR2) zueinander verdreht. Dieser Kompass weist gegenüber den bislang bekannten eine wesentlich höhere Anzeigegenauigkeit auf.

Der erfindungsgemäße elektronische Kompass hat den weiteren besonderen Vorteil, dass sich nicht der Magnetfeldsensor auf das Erdmagnetfeld ausrichten muss, sondern lediglich der Magnet. Der Magnet hat vorteilhafterweise eine sehr geringe Masse und ist leicht drehbar gelagert. Er kann beispielsweise wie eine Kompassnadel eines herkömmlichen Kompasses ausgebildet und gelagert sein.

Bei dem erfindungsgemäßen elektronischen Kompasses weist der elektronische Magnetfeldsensor vorteilhafterweise eine feste Bezugsachse auf und ist ein Ausgangssignal des elektronischen Magnetfeldsensors von einem zwischen der festen Bezugsachse und der Richtung des Magnetfeldes eingeschlossenen Drehwinkel abhängig.

Der elektronische Magnetfeldsensor weist mindestens einen Magnetowiderstand mit einer festen Bezugsachse auf, dessen elektrischer Widerstand von einem Drehwinkel zwischen der festen Bezugsachse und der Richtung des Magnetfeldes abhängig ist. Die Differentialbrückenschaltung liefert im Betrieb des Kompasses eine von dem Drehwinkel abhängige Ausgangsspannung.

Bei einer besonders bevorzugten Ausführungsform ist der bzw. sind die Magnetowiderstände als Giant-Magnetowiderstände (Giant-MR) ausgebildet. Diese sind beispielsweise in der EP 680 614 beschrieben und werden von daher an dieser Stelle nicht mehr näher erläutert. Der Vorteil der Giant-MRs besteht darin, daß sie einen Effekt von bis zu 70% aufweisen können.

Eine besonders bevorzugte Weiterbildung des erfindungsgemäßen elektronischen Kompasses weist mindestens eine erste und eine zweite Differential-Brückenschaltung mit jeweils mindestens einem Magnetowiderstand auf, wobei die Bezugsachsen der Magnetowiderstände der ersten und der zweiten Differential-Brückenschaltung um einen Winkel δ ≠ 0°,180°,360°, vorzugsweise δ = 90°, verdreht zueinander angeordnet sind.

Dies hat den besonderen Vorteil, dass die Ausgangssignale der beiden Differential-Brückenschaltungen, typischerweise sinusförmige Spannungssignale, bei Drehung des Magneten bezüglich der Zeitachse versetzt zueinander angeordnet sind. Dadurch ist eine eindeutige Bestimmung der Orientierung der Bezugsachse zum Erdmagnetfeld gewährleistet.

Der erfindungsgemäße elektronische Kompass wird im folgenden anhand eines Ausführungsbeispieles in Verbindung mit den Figuren 1 bis 5 näher erläutert. Es zeigen:
Figur 1 eine schematische Darstellung des Ausführungsbeispieles,
Figur 2 eine schematische Darstellung einer ersten Ausführungsform einer Differential-Brückenschaltung,
Figur 3 eine schematische Darstellung einer zweiten Ausführungsform einer Differential-Brückenschaltung und
Figur 4 eine schematische Darstellung eines erfindungsgemäßen Magnetfeldsensors mit zwei hinsichtlich ihrer Bezugsachsen zueinander verdrehten Differential-Brückenschaltungen und
Figur 5 eine schematische Darstellung des Signalverlaufes bei Verwendung von zwei Differential-Brückenschaltungen, bei denen die Bezugsachsen der magnetfeldabhängigen elektrischen Widerstandselemente um 90° verdreht zueinander angeordnet sind und sich der Magnet um insgesamt 360° gegenüber dem Magnetfeldsensor dreht.

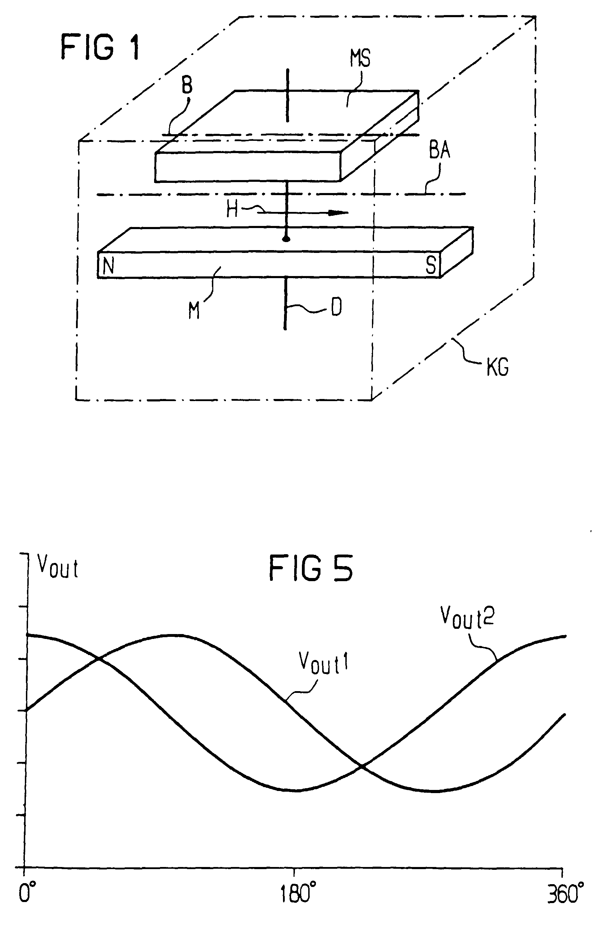

Bei dem Ausführungsbeispiel gemäß Figur 1 ist auf einer gemeinsamen, in einem Kompassgehäuse KG mit einer Bauteilachse BA befestigten Drehachse D ein drehbar gelagerter Magnet M (z. B. eine Kompassnadel) mit einem einen Nordpol N und einen Südpol S aufweisenden Magnetfeld H angeordnet. Über diesem befindet sich ein fest und unverdrehbar mit der Drehachse D und damit auch fest und unverdrehbar mit dem Kompassgehäuse KG verbundener Magnetfeldsensor MS mit mindestens einer festen Bezugsachse B.

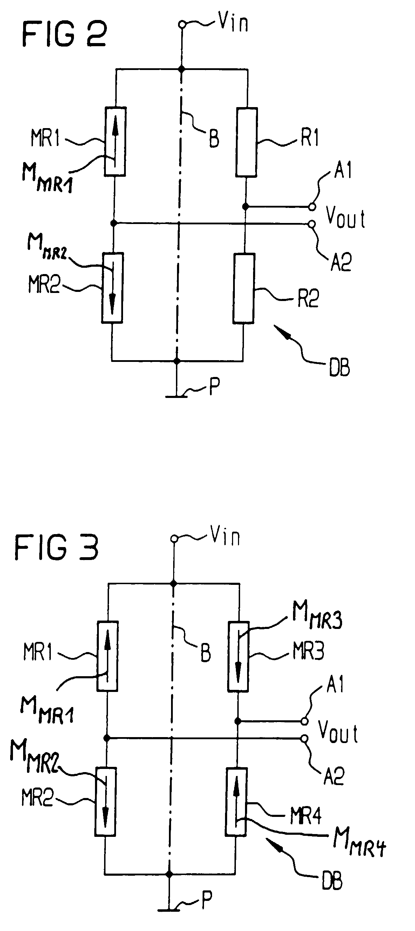

Die in den Figuren 2 und 3 gezeigten Beispiele für Differential-Brückenschaltungen können bei dem Ausführungsbeispiel von Figur 1 wahlweise als Magnetfeldsensor MS eingesetzt werden.

Bei der in Figur 2 dargestellten Differential-Brückenschaltung DB ist eine Serienschaltung aus zwei Magnetowiderständen MR1, MR2 vorgesehen, deren Magnetisierungen M_{MR1}, M_{MR2} (angedeutet durch Pfeile in den Bauteilsymbolen) aufeinander zu gerichtet sind. Dies stellt hinsichtlich der Größe des Ausgangssignals die ideale Anordnung dar, es ist jedoch auch jede andere Anordnung der Magnetisierungen M_{MR1}, M_{MR2} zueinander verwendbar. Parallel zu den beiden Magnetowiderständen MR1,MR2 ist eine Reihenschaltung aus zwei Festwiderständen R1,R2 geschaltet. Diese Parallelschaltung ist einerseits mit einer Versorgungsspannung Vᵢₙ und andererseits mit einem festen Bezugspotential P verbunden. Der Mittelabgriff zwischen den beiden Magnetowiderständen MR1,MR2 ist mit einem ersten Anschluss A1 und der Mittelabgriff zwischen den beiden Festwiderständen R1,R2 ist mit einem zweiten Anschluss A2 verbunden. An diesen beiden Anschlüssen A1,A2 ist eine von den Widerstandswerten der Magnetowiderstände MR1,MR2 abhängige Ausgangsspannung Vₒᵤₜ der Differential-Brückenschaltung DB abgreifbar. Die beiden Magnetowiderstände MR1,MR2 sind vorzugsweise Giant-MRs.

Bei der in Figur 3 dargestellten Differential-Brückenschaltung DB sind an Stelle der beiden Festwiderstände R1,R2 der Ausführungsform von Figur 2 vorteilhafterweise ebenfalls zwei Magnetowiderstände MR3,MR4 vorgesehen. Die Magnetisierung M_{MR3} des Magnetowiderstandes MR3 ist entgegengesetzt zur Magnetisierung M_{MR1} des Magnetowiderstandes MR1 und die Magnetisierung M_{MR4} des Magnetowiderstandes MR4 ist entgegengsetzt zur Magnetisierung M_{MR2} des Magnetowiderstandes MR2 gerichtet. Dies stellt hinsichtlich der Größe des Ausgangssignals wiederum die ideale Anordnung dar, es ist jedoch auch jede andere Anordnung der Magnetisierungen M_{MR1},M_{MR2},M_{MR3},M_{MR4} zueinander verwendbar. Der sonstige Aufbau dieser Brückenschaltung DB entspricht dem der Brückenschaltung DB von Figur 2. Die zuletzt beschriebene Schaltungsanordnung hat insbesondere den Vorteil, dass ein vergleichsweise großes Ausgangssignal Vₒᵤₜ erzeugt wird. Sämtliche Magnetowiderstände MR1 - MR4 sind vorzugsweise Giant-MRs.

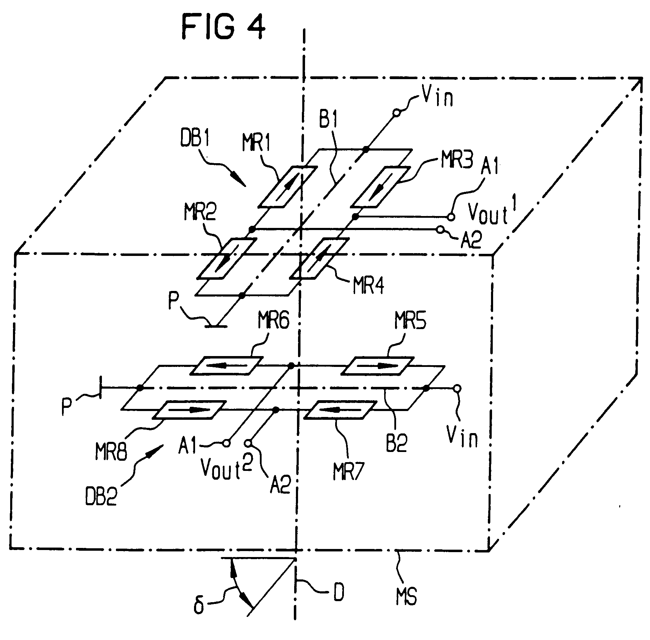

Bei der in Figur 4 schematisch dargestellten Ausführungsform eines Magnetfeldsensors MS für den Einsatz in einem erfindungsgemäßen elektronischen Kompass ist eine erste Differential-Bruckschaltung DB1 gemäß Figur 3 mit einer ersten Bezugsachse B1 und eine zweite Differential-Brückenschaltung DB2 gemäß Figur 3 mit einer zweiten Bezugsachse B2 vorgesehen. Hierbei sind die erste und die zweite Bezugsachse B1,B2 derart zueinander orientiert, daß sie, projiziert auf eine senkrecht zu einer Drehachse D des Magneten M liegenden Ebene, einen rechten Winkel δ einschließen. Die Bezugsachsen B1,B2 sind durch die Magnetowiderstände MR1 - MR8 definiert. Ein derartiger Magnetfeldsensor MS kann alternativ natürlich auch mit Differential-Brückschaltungen DB gemäß Figur 2 ausgebildet sein. Ebenso kann der von den Bezugsachsen B1,B2 eingeschlossene Winkel δ einen anderen Wert größer als 0° aber ungleich 180° oder 360° aufweisen. Je kleiner der Winkel δ, oder besser ausgedrückt, je weiter der Winkel δ von 90° oder 270° abweicht, umso geringer ist jedoch die Differenz (Phasenunterschied) zwischen den beiden Ausgangsspannungen Vₒᵤₜ1 und Vₒᵤₜ2 an den Differential-Brückenschaltungen DB1 und DB2.

Das in Figur 5 gezeigte Diagramm eines Ausgangssignalverlaufs eines erfindungsgemäßen elektronischen Kompasses mit einem Magnetfeldsensor MS gemäß Figur 4 bei einer Drehung des Magneten M um 360° um die Drehachse D (Abszisse: Drehwinkel, Ordinate: Spannung) weist zwei sinusförmige Ausgangsspannungen Vₒᵤₜ1 und Vₒᵤₜ2 der beiden Differential-Brückenschaltungen DB1 und DB2 auf. Diese beiden sinusförmigen Ausgangsspannungen Vₒᵤₜ1 und Vₒᵤₜ2 sind entsprechend dem Winkel δ, hier also um 90° zueinander versetzt, so dass jeder Orientierung des Magnetfeldes H des Magneten M zum Magnetfeldsensor MS eindeutig ein Ausgangsspannungswertepaar (Vₒᵤₜ1,Vₒᵤₜ2) zugeordnet ist. Dadurch ist anhand des Ausgangsspannungswertepaares (Vₒᵤₜ1,Vₒᵤₜ2) eine eindeutige Bestimmung der Orientierung des Magneten M und folglich auch des Erdmagentfeldes gegenüber dem Magnetfeldsensor MS möglich.

## Patentansprüche

1. Elektronischer Kompass mit einem elektronischen Magnetfeldsensor (MS), bei dem
der elektronische Magnetfeldsensor (MS) gegenüber einem Kompassgehäuse (KG) fest positioniert ist,
ein gegenüber dem Magnetfeldsensor (MS) drehbar gelagerter, sich selbständig auf das Erdmagnetfeld ausrichtender Magnet (M) vorgesehen ist,
sich der elektronische Magnetfeldsensor (MS) im Einflußbereich eines vom Magneten (M) erzeugten Magnetfeldes (H) befindet,
der elektronische Magnetfeldsensor (MS) einen ersten Magnetowiderstand (MR1) mit einer festen Bezugsachse (B1) aufweist, dessen elektrischer Widerstand von einem Drehwinkel (α) zwischen der festen Bezugsachse (B1) und der Richtung des Magnetfeldes (H) abhangig ist, und
der Magnetowiderstand (MR1) in einer Differential-Brückenschaltung (DB) angeordnet ist, die im Betrieb des Kompasses eine von dem Drehwinkel (α) abhängige Ausgangsspannung (Vₒᵤₜ1) liefert,
**dadurch gekennzeichnet**,
dass die Differential-Brückenschaltung (DB1) einen zweiten Magnetowiderstand (MR2) aufweist, und
dass die Magnetisierungen (M_{MR1}, M_{MR2}) des ersten (MR1) und des zweiten Magnetowiderstand (MR2) zueinander verdreht sind.

2. Elektronischer Kompass nach Anspruch 1,
**dadurch gekennzeichtnet,**
dass die Differential-Brückenschaltung (DB1) aufweist:
eine erste Reihenschaltung, die den ersten (MR1) und den zweiten Magnetowiderstand (MR2) aufweist, und
eine zweite Reihenschaltung, die zwei Festwiderstände (R1,R2) aufweist und parallel zur ersten Reihenschaltung geschaltet ist,
dass die erste und die zweite Reihenschaltung einerseits mit einer Versorgungsspannung (Vᵢₙ) und andererseits mit einem festen Potential (P) verbunden sind
und dass an den Mittelabgriffen (A1,A2) der ersten und der zweiten Reihenschaltung im Betrieb des Kompasses die Ausgangsspannung (Vₒᵤₜ1) des Magnetfeldsensors (MS) abgreifbar ist.

3. Elektronischer Kompass nach Anspruch 2,
**dadurch gekennzeichnet**, dass
die Magnetisierungen (M_{MR1},M_{MR2}) der beiden Magnetowiderstände (MR1, MR2) der ersten Reihenschaltung im Wesentlichen entgegensetzt zueinander gerichtete sind.

4. Elektronischer Kompass nach Anspruch 1,
**dadurch gekennzeichtnet,**
dass die Differential-Brückenschaltung (DB1) aufweist:
eine erste Reihenschaltung, die den ersten (MR1) und den zweiten Magnetowiderstand (MR2) aufweist, und
eine zweite Reihenschaltung, die weitere zwei Magnetowiderstände (MR3,MR4) aufweist und parallel zur ersten Reihenschaltung geschaltet ist,
dass die erste und die zweite Reihenschaltung einerseits mit einer Versorgungsspannung (Vᵢₙ) und andererseits mit einem festen Potential (P) verbunden sind
und dass an den Mittelabgriffen (A1,A2) der ersten und der zweiten Reihenschaltung im Betrieb des Kompasses die Ausgangsspannung (Vₒᵤₜ1) des Magnetfeldsensors (MS) abgreifbar ist.

5. Elektronischer Kompass nach Anspruch 4,
**dadurch gekennzeichtnet,** dass
die zwei Magnetowiderstände (MR1,MR2) der ersten Reihenschaltung Magnetisierungen (M_{MR1}, M_{MR2}) aufweisen, die zueinander verdreht sind und dass auch die Magnetowiderstände (MR3,MR4) der zweiten Reihenschaltung Magnetisierungen (M_{MR3}, M_{MR4}) aufweisen, die zueinander verdreht sind.

6. Elektronischer Kompass nach Anspruch 5,
**dadurch gekennzeichnet**, dass
die Magnetisierungen (M_{MR1},M_{MR2}) der beiden Magnetowiderstände (MR1, MR2) der ersten Reihenschaltung im Wesentlichen entgegensetzt zueinander gerichtete sind und daß auch die Magnetisierungen (M_{MR3}, _{MMR4}) der beiden Magnetowiderstände (MR3, MR4) der zweiten Reihenschaltung im Wesentlichen entgegengesetzt zueinander gerichtet sind, wobei bei einer der beiden Reihenschaltungen die Magnetisierungen aufeinander zu gerichtet sind und bei der anderen voneinander weg gerichtet sind.

7. Elektronischer Kompaß nach einem der Ansprüche 1 bis 6,
**dadurch gekennzeichtnet,** dass
der elektronische Magnetfeldsensor (MS) einen dritten Magnetowiderstand (MR5) mit einer weiteren festen Bezugsachse (B2) aufweist, die derart verdreht zur Bezugsachse (B1) des ersten Magnetowiderstandes (M1) angeordnet ist,
daß die beiden Bezugsachsen (B1,B2), projiziert auf eine parallel zur Drehebene des Magneten (M) liegende Ebene, einen Winkel δ ≠ 0°, 180°, 360°, vorzugsweise δ = 90°, einschließen, und
dass der elektrische Widerstand des dritten Magnetowiderstands (MR5) von einem weiteren Drehwinkel (β) zwischen der festen Bezugsachse (B2) des dritten Magnetowiderstandes (MR5) und der Richtung des Magnetfeldes (H) abhängt.

8. Elektronischer Kompass nach Anspruch 7,
**dadurch gekennzeichtnet,** dass
der dritte Magnetowiderstand (MR5) in einer weiteren Differential-Brückenschaltung (DB2) angeordnet ist, die im Betrieb des Kompasses eine von dem Drehwinkel (β) abhängige weitere Ausgangsspannung (Vₒᵤₜ2) liefert.

9. Elektronischer Kompass nach Anspruch 8,
**dadurch gekennzeichtnet,**
dass die weitere Differential-Brückenschaltung (DB2) aufweist:
eine erste Reihenschaltung, die den dritten (MR5) und einen vierten Magnetowiderstand (MR6) aufweist, und
eine zweite Reihenschaltung, die zwei Festwiderstände aufweist und parallel zur ersten Reihenschaltung geschaltet ist,
dass die erste und die zweite Reihenschaltung einerseits mit einer Versorgungsspannung (Vᵢₙ) und andererseits mit einem festen Potential (P) verbunden sind
und dass an den Mittelabgriffen (A1,A2) der ersten und der zweiten Reihenschaltung im Betrieb des Kompasses die Ausgangsspannung (Vₒᵤₜ2) des Magnetfeldsensors (MS) abgreifbar ist.

10. Elektronischer Kompass nach Anspruch 9,
**dadurch gekennzeichtnet,** dass
die beiden Magnetowiderstände (MR5,MR6) der ersten Reihenschaltung Magnetisierungen (M_{MR5}, M_{MR6}) aufweisen, die zueinander verdreht sind.

11. Elektronischer Kompass nach Anspruch 9,
**dadurch gekennzeichnet**, dass
die Magnetisierungen (M_{MR5},M_{MR6}) der beiden Magnetowiderstände (MR5, MR6) der ersten Reihenschaltung im Wesentlichen entgegensetzt zueinander gerichtet sind.

12. Elektronischer Kompass nach Anspruch 8,
**dadurch gekennzeichtnet,**
dass die weitere Differential-Brückenschaltung (DB2) aufweist:
eine erste Reihenschaltung, die den dritten (MR5) und einen vierten Magnetowiderstand (MR6) aufweist, und
eine zweite Reihenschaltung, die weitere zwei Magnetowiderstände (MR7,MR8) aufweist und parallel zur ersten Reihenschaltung geschaltet ist,
dass die erste und die zweite Reihenschaltung einerseits mit einer Versorgungsspannung (Vᵢₙ) und andererseits mit einem festen Potential (P) verbunden sind
und dass an den Mittelabgriffen (A1,A2) der ersten und der zweiten Reihenschaltung im Betrieb des Kompasses die Ausgangsspannung (Vₒᵤₜ2) des Magnetfeldsensors (MS) abgreifbar ist.

13. Elektronischer Kompass nach Anspruch 12,
**dadurch gekennzeichtnet,** dass
die zwei Magnetowiderstände (MR5,MR6) der ersten Reihenschaltung Magnetisierungen (M_{MR5}, M_{MR6}) aufweisen, die zueinander verdreht sind und dass auch die Magnetowiderstände (MR7,MR8) der zweiten Reihenschaltung Magnetisierungen (M_{MR7}, M_{MR8}) aufweisen, die zueinander verdreht sind.

14. Elektronischer Kompass nach Anspruch 12,
**dadurch gekennzeichnet**, dass
die Magnetisierungen (M_{MR5},M_{MR6}) der beiden Magnetowiderstände (MR5, MR6) der ersten Reihenschaltung im Wesentlichen entgegensetzt zueinander gerichtete sind und daß auch die Magnetisierungen (M_{MR7}, M_{MMR8}) der beiden Magnetowiderstände (MR7, MR8) der zweiten Reihenschaltung im Wesentlichen entgegengesetzt zueinander gerichtet sind, wobei bei einer der beiden Reihenschaltungen die Magnetisierungen aufeinander zu gerichtet sind und bei der anderen voneinander weg gerichtet sind.

15. Elektronischer Kompass nach einem der Ansprüch 1 bis 14,
**dadurch gekennzeichtnet,** dass
der Magnetowiderstand bzw. die Magnetowiderstände (MR1 bis MR8) als Giant-Magnetowiderstände ausgebildet sind.
